## Europäisches Patentamt
## European Patent Office
## Office européen des brevets

(19)

(11) Numéro de publication: **0 109 996**
**B1**

(12) **FASCICULE DE BREVET EUROPEEN**

(45) Date de publication du fascicule du brevet: **03.06.87**

(51) Int. Cl.⁴: **H 01 L 29/86**, H 01 L 27/02

(21) Numéro de dépôt: **82430037.0**

(22) Date de dépôt: **26.11.82**

(54) **Structure de résistance autopolarisée et application à la réalisation de circuits d'interface.**

(43) Date de publication de la demande:
**13.06.84 Bulletin 84/24**

(45) Mention de la délivrance du brevet:
**03.06.87 Bulletin 87/23**

(84) Etats contractants désignés:
**DE FR GB IT**

(56) Documents cités:
**FR-A-2 351 505**
**FR-A-2 390 011**

**IBM TECHNICAL DISCLOSURE BULLETIN, vol. 13, no. 6, novembre 1970, page 1645, New York, USA. G. AGUSTA: "DC bias for epi pocket pulse applications"**

**IBM TECHNICAL DISCLOSURE BULLETIN, vol. 14, no. 11, avril 1972, page 3339, New York, USA. H. C. CALHOUN et al.: "Low-capacitance diffused resistor"**

**PATENTS ABSTRACTS OF JAPAN, vol. 6, no. 155, 17 aou7t 1982, page (E-125)1033r**

(73) Titulaire: **International Business Machines Corporation**
**Old Orchard Road**
**Armonk, N.Y. 10504 (US)**
(84) **DE GB IT**

(73) Titulaire: **Compagnie IBM FRANCE**
**5 Place Vendôme**
**F-75000 Paris 1er (FR)**
(84) **FR**

(72) Inventeur: **Delaporte, François-Xavier**
**36 chemin de Saint-Laurent**
**F-06800 Cagnes/Mer (FR)**
Inventeur: **Lebesnerais, Gérard Maxime**
**9 rue des Prés Saint Germain sur Ecole**
**F-77930 Perthes (FR)**
Inventeur: **Pantani, Jean-Pierre**
**239 Boulevard du Mont Boron B5**
**F-06300 Nice (FR)**

(74) Mandataire: **Klein, Daniel Jacques Henri**
**Compagnie IBM France Département de Propriété Intellectuelle**
**F-06610 La Gaude (FR)**

Courier Press, Leamington Spa, England.

## Description

La présente invention concerne le domaine des résistances intégrées sous forme monolithique dans un cristal de semi-conducteur, typiquement du silicium et plus particulièrement une résistance autopolarisée dont les caractéristiques d'entrée sont indépendantes des tensions d'alimentation dudit cristal. Elle concerne également l'utilisation de telles résistances dans les circuits d'interface des équipements périphériques des ordinateurs.

Il existe de nombreuses configurations de réseau, par exemple celles du type bouclé, où un ordinateur, un controleur de communications (ou tout autre système de traitement de l'information) est relié à des dizines ou même des certaines d'équipements périphériques tels que terminaux, modems, etc., dans lesquels les caractéristiques des circuits d'entrée de ces périphériques doivent rester constantes et déterminées que ces périphériques soient en marche ou à l'arrêt.

Dans un tel système, il ne faut pas que la mise en marche ou l'arrêt d'un équipment ou d'un autre apporte des perturbations au fonctionnement des équipements restés en marche.

Par ailleurs, il est souhaitable que ces circuits d'entrée puissent s'adapter à des niveaux de signaux que des équipements, différents ou manufacturés par des fournisseurs différents, sont susceptibles de produire.

Les circuits d'entrée des modems, essentiellement constituées par des circuits d'interface incorporés à des récepteurs, doivent répondre à cettre double exigence. Les circuits d'interface sont déterminés à partir de standards internationaux ou normes, qui définissent les protocoles d'échange des données, c'est à dire un ensemble de règles qui concernent aussi bien le matériel que le logical.

Une norme classique dans le domaine de la transmission de données est la norme EIA RS 232C (ou CCITT V24) dont certaines règles peuvent rendre quelque peu difficile la réalisation de ces circuits d'entrée sous forme intégrée monolithique. Or les avantages d'une solution entièrement monolithique sont tellement évidents à tous les points de vue: cout, encombrement, fiabilité, etc., qu'une telle solution est réellement désirable. Une de ces règles, stipule que les signaux d'entrée $V_{in}$, qui peuvent être appliqués sur l'entrée du récepteur peuvent prendre des valeurs −15V et +15V. Avec les circuits logiques de type TTL couramment utilisés, il est souhaitable d'utiliser des tensions d'alimentation +Vcc=8,5V et −Vcc=−8,5V. Il faut noter même que ces dernières tensions ont tendance à évoluer vers des valeurs encore plus faibles.

Dans les réalisations intégrées sous forme planar monolithique, on sait que les variations des signaux d'entrée et de sortie doivent rester comprises entre les les valeurs (+Vcc et −Vcc fournies par les circuits d'alimentation. Cette limitation, quasi générale, vient du fait que dans les applications de type analogique, la technique d'isolement des dispositifs élémentaires: transistors, diodes, résistances, etc. intégrés sur un même cristal ou microplaquette de silicium, est basée sur des jonctions PN polarisées en inverse. Par exemple, dans le cas d'une résistance, on sait que celle ci est obtenue en formant une région diffusée de type P, ou corps, dans une couche épitaxiale de type N. Le potentiel de la couche épitaxiale doit être supérieur à tous les potentiels existant le long du corps de la résistance, quels que soient les signaux appliqués à la résistance. Dans ces seules conditions, la jonction PN est toujours polarisée en inverse dans le sens bloquant. Normalement, une tension fixe fournie par les circuits d'alimentation plus positive que tous les signaux existants aux bornes de la résistance, est appliquée à la couche épitaxiale.

Cet enseignement est classique; on pourra se référer par exemple à l'ouvrage "Integrated Circuits, Design Principles and Fabrication—Motorola series in Solid State Electronics" publié par McCraw Hill pages 258—259.

Cependant, la couche épitaxiale peut ne pas être polarisée et sont potentiel laissé flottant comme cela est décrit dans l'article paru dans l'IBM Technical Disclosure Bulletin, Vol. 14 n°11, avril 1972, page 3339, intitulé: "Low Capacitance Diffused Resistor".

Une première solution au problème posé par l'existence de tensions d'alimentations, de valeurs inférieures à celles des signaux d'entrée, serait donc de prévoir un circuit d'alimentation supplémentaire pour assurer cette fonction d'isolement. Cette solution n'est pas souhaitable en raison de son coût élevé.

Un premier objet de l'invention est donc de fournir un circuit d'interface intégré sous forme monolithique dont les caractéristiques d'entrée sont indépendantes de la présence ou de l'absence des tensions d'alimentation.

Un autre objet de l'invention est de fournir un circuit d'interface intégré sous forme monolithique qui puisse recevoir des tensions d'entrée supérieures en valeur absolue aux tensions d'alimentation.

Encore un autre objet de la présente invention est de fournir une structure de résistance autopolarisée destinée à être utilisée dans ledit circuit d'interface.

Les objets sont avantageusement réalisés en accord avec les enseignements de la présente invention.

Le problème à la base de l'invention est résolu de la manière indiquée en détail dans la revendication 1. D'autres modes de réalisation sont mentionnés dans les sous-revendications.

On propose un circuit d'interface intégré sous forme monolithique composé essentiellement d'un atténuateur résistif dont la fonction est de diviser les signaux d'entrée $V_{in}$, dans un rapport tel que les signaux $V_{out}$ fournis par le circuit d'interface deviennent inférieurs aux tensions d'alimentations. Ainsi, le récepteur proprement dit qui est attaqué par les signaux $V_{out}$ peut être rendu facilement intégrable sous forme monolithique.

Une caractéristique essentielle de la présente invention est que l'on propose des moyens pour auto polariser cet atténuateur résistif à partir des signaux d'entrée.

La résistance de l'atténuateur est disposé seule dans un caisson isolé de la couche épitaxiale. Elle reçoit le signal $V_{in}$ sur une extrémité, et l'autre extrémité est au potentiel de la masse. Une prise intermédiaire fournit $V_{out}$, le signal de sortie. Dans un autre caisson, une diode est montée entre la borne où est appliquée la tension d'entrée $V_{in}$ et la couche épitaxiale, une capacité est montée entre la couche épitaxiale et la masse. Quand la tension d'entrée $V_{in}$ est positive, la capacité C est chargée et maintient le potentiel de l'épitaxie à un potentiel proche de $V_{in}$ de sorte que la polarisation de la jonction formée entre le corps de la résistance et la couche épitaxiale est toujours voisine de 0 volt, assurant ainsi un parfait isolément.

La présente invention sera plus facilement comprise à l'aide de la description qui va suivre, faite en référence aux figures annexées à ce texte, qui représentent deux modes de réalisation préférée de l'invention dans lesquelles:

La figure 1 représente une vue en coupe d'une structure de résistance R autopolarisée par une structure complémentaire diode-capacité DC, l'ensemble formant le circuit d'interface conforme aux enseignements de la présente invention.

La figure 2 représente le schéma électrique équivalent de la structure montrée sur la figure 1.

La figure 3 représente une vue de dessus de la structure de résistance R autopolarisée de la figure 1, dans un autre mode de réalisation.

Pour permettre la réalisation complète d'un récepteur conforme aux normes EIA RS 232C, la présente invention propose d'utiliser d'abord un circuit d'interface simplement composé d'un atténuateur résistif formé de deux résistances R1 et R2 dont la valeur est choisie de telle sorte que les tensions d'entrée soient rendues inférieures aux tensions d'alimentations. Dans l'exemple précité, la tension $V_{in}$ est égale à ±15V et Vcc=±8,5; en choisissant R1−R2 on aura donc à la sortie de l'atténuateur $V_{out}$=±7,5V. Tous les circuits du récepteur qui seront attaqués par cette tension pourront donc être intégrés sans difficulté.

On comprendra qu'avec d'autres normes (ex: EIA RS 232 A—B où $V_{in}$=±25V) et où avec d'autres tensions d'alimentation Vcc, ce principe reste identique, il suffira de choisir les valeurs R1 et R2 appropriées.

On pourrait bien sur réaliser ce circuit d'interface avec des résistances discrètes, qui ne connaissent évidemment pas ces problèmes d'isolement. Cela conduirant soit, à une solution de type hybride très coûteuse résistance à films minces associées à des micro plaquettes intégrées soit, à une solution archaïque: montage direct des résistances par soudure sur les modules contenant les récepteurs intégrés sous forme monolithique.

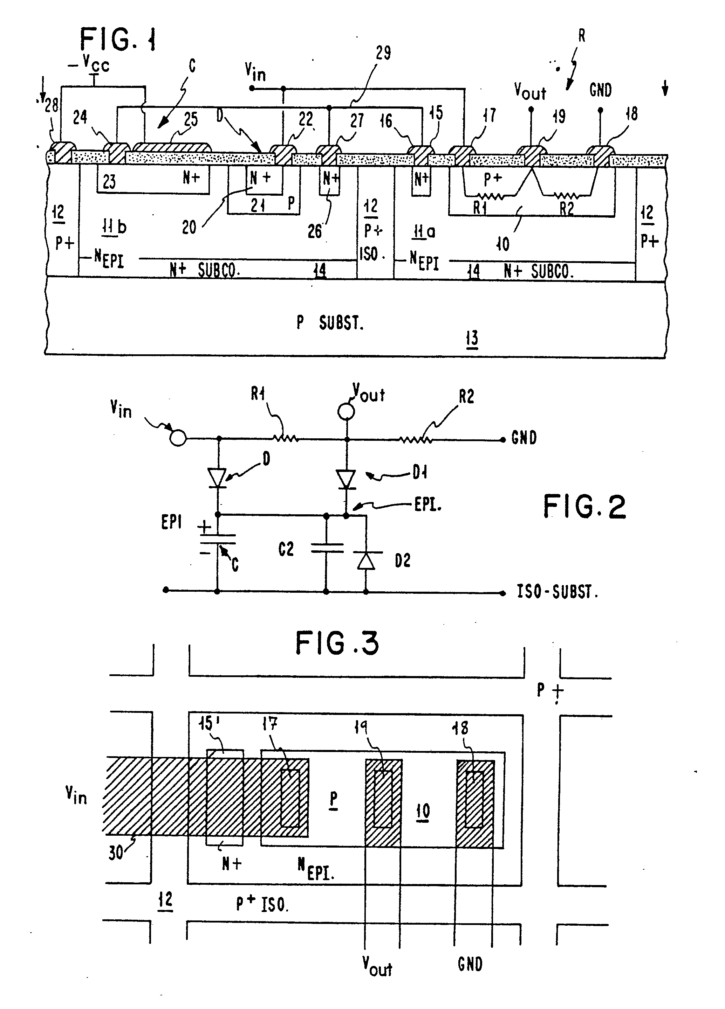

La figure 1 représente une vue en coupe, d'une résistance R intégrée de façon classique dans une micro plaquette de silicium. Le corps de la résistance 10 est obtenu par la formation d'une région de type P, simultanément à la formation des régions de base des transistors NPN de la microplaquette, dans la couche épitaxiale 11 de type N. La résistance R est disposée dans une portion 11a de la couche épitaxiale formant un caisson qui est isolé de façon classique par des murs d'isolement 12 de type P+ qui rejoignent le substrat de silicium 13 de type P. Une région de sous collecteur 14 peut avantageusement être disposée au fond du caisson. La structure de résistance R comporte également une région ou pavé de type N+ 15, formée simultanément avec les émetteurs, qui assure un bon contact avec la couche épitaxiale. C'est le contact de cette région 15 qui est relié normalement au potentiel le plus positif existant sur la micro plaquette pour assurer la polarisation en inverse de la jonction EPITAXIE SUBSTRAT-ISOLEMENT. La résistance R est composée de deux résistances R1 et R2 égales. La tension d'entrées $V_{in}$ est appliquée à une borne 17 de la résistance R tandis que le potentiel de la masse GND est appliqué sur l'autre borne 18. La tension $V_{out}$ telle que

$$V_{out}=\frac{V_{in}}{2}$$

est donc obtenue sur la borne 19 disposée au centre de la résistance R. La tension $V_{out}$ est appliquée comme tension d'entrée au récepteur (non représenté). On associe à la structure de résistance R, une structure complémentaire composée d'une diode D et d'une capacité C et formée dans un caisson 11b. La diode D est réalisée de façon classique par la jonction base-collecteur d'un transistor NPN dont la jonction émetteur-base, formée entre les régions N+ 20 et P 21, est court-circuitée par le contact 22. La capacité C qui est représentée ici est de type MOS, une électrode est constituée par la région de type N+ 23 et son contact 24, l'autre électrode est constituée par la métallisation 25.

Cette structure comporte également un pavé de type N+ 26 qui assure un bon contact avec la portion de la couche épitaxiale 11 de ce caisson. Le pavé 26 est muni d'un contact 27. Un contact 28 est formé sur l'un des murs d'isolement 12, pour appliquer à l'ensemble SUBSTRAT-ISOLEMENT le potentiel le plus négatif disponible sur la micro plaquette, c'est à dire −Vcc. Cet ensemble donc porté au −Vcc en courant continu (DC) doit être compris comme étant relié à la masse, en courant alternatif (AC) en raison des condensateurs de découplage des circuits d'alimentation.

La structure de la résistance R constitue la base du circuit d'interface dont on a parlé ci-dessus, elle est donc formée dans ce cas des deux résistances égales R1=R2 destinées à diviser par 2 les tensions $V_{in}$. Pour la mise en oeuvre de l'invention, il est impératif que chaque résistance R soit contenue dans un caisson isolé, même si la microplaquette comporte une pluralité de circuits d'interface et de récepteurs correspondants. Comme on le voir sur la figure 1, la tension $V_{in}$ est également appliquée à l'anode de la diode D. La cathode de cette diode qui est constituée en fait par la couche épitaxiale 11 de type N est donc en série avec celle des électrodes de la capacité C constituée par la région 23 de type n+. Cette région 23, le pavé 26 et le pavé 15, sont interconnectés entre eux par la ligne 29 dont le potentiel électrique est celui de la couche épitaxiale. On observera que ces régions ne sont pas reliées à un potentiel extérieur, la couche épitaxiale est donc apparemment laissée "flottante", à la différence des structures de l'art antérieur où tous les caissons sont portés à un potentiel fixe, généralement celui d'une alimentation, le plus positif existant sur la microplaquette. L'autre électrode de la capacité C c'est à dire la métallisation 25 est reliée à l'ensemble SUBSTRAT-ISOLEMENT c'est à dire à la masse en régime alternatif.

Le fonctionnement sera mieux compris à l'aide de la figure 2 qui représente le schéma électrique équivalent du circuit d'interface de la figure 1. Les mêmes éléments portant les mêmes références, on a simplement ajouté la diode D1 qui représente l'ensemble des diodes réparties formées entre le corps 10 de la résistance et la couche épitaxiale 11, la diode D2 qui représente l'ensemble des diodes réparties de la jonction formée entre la couche épitaxiale 11 et l'ensemble SUBSTRAT-ISOLEMENT, et enfin la capacité C2 qui représente l'ensemble des capacités réparties de cette me jonction.

Supposons qu'à l'instant t0, toutes les régions soient au potentiel 0V à l'exception bien sur de l'ensemble SUBSTRAT-ISOLEMENT qui est au potentiel −Vcc, par exemple −8,5V. Quand $V_{in}$ est porté à une tension positive de +15V, la diode D est polarisée en direct entre le +15V appliqué et le −8,5V, et un courant va se développer qui chargera la capacité C à un potentiel proche de +15V. La valeur de ce courant est déterminée essentiellement par la valeur de la résistance de la diode (faible) et de la valeur de la capacité que le concepteur de circuit peut ajuster à sa guise en jouant notamment sur les dimensions des électrodes 23 et 25 de la capacité C.

On a intérêt à choisir la valeur de C suffisamment faible pour que le circuit de polarisation D, C apparaisse pour l'extérieur comme un circuit à très haute impédance, mais suffisamment forte cependant pour conserver la charge pendant les alternances négatives du signal.

La capacité C étant chargée à un potentiel de −15V, va polariser positivement les différentes portions de la couche épitaxiale, isolées dans des caissons différents, notamment celui de la résistance R, grâce à l'interconnection 29 qui relie la région 23 au pavé 15. La jonction formée entre le corps de la résistance 10 et la couche épitaxiale 11 est pratiquement polarisée à une tension nulle et ledit corps peut être considéré comme isolé.

Cet état durera tant que $V_{in}$ sera maintenu à cette tension positive de 1+15V. Si maintenant $V_{in}$ passe au potentiel de −15V, la diode D aussi bien que la diode D1 se trouvent polarisées en inverse en raison de la charge de la capacité C. Cette capacité C maintiendra un potentiel proche de +15V, pour autant que les courants de fuite ne la déchargent pas. Les courants de fuite viennent essentiellement de la résistance parasite qui existe aux bornes de la diode D2, qui est cependent considérable (1000 MΩ). On a observé que pour des signaux $V_{in}$ qui changent très lentement de polarité, le potentiel de l'épitaxie suit approximativement $V_{in}$ maintenant une polarisation nulle (et donc un courant nul) aux bornes de la jonction: corps de la résistance/couche épitaxiale.

On remarquera enfin pour être complet, que si à t0, $V_{in}$ est porté à une tension négative de −15V, ce qui a été dit ci-dessus ne s'applique pas, mais l'ensemble fonctionne néanmoins correctement. En effet, la diode D2 conduit entre le −8,5V et le −15V, à travers la résistance parasite parallèle sur D1, le potentiel de la couche épitaxiale se stabilise alors au potentiel de l'ensemble ISOLEMENT-SUBSTRAT à la chute de tension $V_D$ aux bornes de la diode D2 près, soit à environ (8,5+0,5V)=−9V mais l'isolement est quand même assuré puisque la jonction entre le corps de la résistance (porté à $V_{in}$=−15V) et la couche épitaxiale (portée à −9V) est polarisée dans le sens bloquant.

On peut vérifier que même dans l'hypothèse Vcc=−8,5 tomberait à zéro volts par rapport à la masse, cet isolement serait quand même assuré.

Dès que $V_{in}$ remonte à +15V, la capacité C se charge, plus ou moins vite selon la durée pendant laquelle $V_{in}$ se maintient à ce niveau, mais très rapidement on arrive à une polarisation quasi permanente de la couche épitaxiale au +15V.

Le pricipe d'autopolarisation d'une résistance intégrée monolithique a été appliqué à un pont diviseur, c'est-à-dire à une résistance munie d'un point intermédiairé. Cependant on peut trouver des applications (résistances de terminaison de lignes, d'adaptation) où le point milieu peut se révéler n'être pas nécessaire.

Le circuit d'interface, composé de l'atténuateur résistif formé par la résistance R présentant un point milieu (où la tension de sortie Vout est disponible) et sa structure d'autopolarisation composée des éléments D et C, est facilement intégrable par tout procédé bipolaire standard, sur la même microplaquette que le récepteur.

La résistance R apparait donc présenter une autopolarisation de son caisson qui est assurée par les signaux d'entrée $V_{in}$ et non plus par une alimentation extérieure. On comprend que si cette alimentation nécessaire aux différents caissons du récepteur, disparait (machine hors fonction) le circuit d'interface continue de présenter les mêmes caractéristiques d'entrée que lorsque la machine était en fonctionnement. Grossièrement on peut considérer que l'autopolarisation de la résistance R s'effectue par un redressement simple alternance de la tension d'entrée $V_{in}$ de type bipolaire grâce à une constante de charge très faible (résistance de la diode D x valeur de la capacité C) et à une constant de décharge très grande (valeur de la résistance de fuite de D2 x valeur de la capacité C).

Un exemple de récepteur qui peut être utilisé est décrit dans la demande de brevet européen No. 82430019.8 déposée par la demanderesse le 28 juillet 1982.

Dans un procédé classique bipolaire pour des applications analogiques classiques, avec l'exemple précité on trouve les valeurs typiques suivantes:

La résistance de couche de la zone diffusée de type P 10 est d'environ 100 à 150 $\Omega/\square$. La couche épitaxiale 11 a environ 10 µm d'épaisseur et sa résistivité est de 1 $\Omega$cm. L'épaisseur de la couche d'oxyde au-dessus de la région 23 est de l'ordre de 250 à 300 nm, ce qui permet de réaliser des capacités de l'ordre de 10pF sur une surface d'environ 0,10 mm².

La résistance R a une valeur généralement comprise entre 3 et 5 k$\Omega$. Par exemple, elle comporte deux éléments de 2,1 k$\Omega$. Pour cette structure on peut choisir la valeur C=10pf mentionnée ci-dessus.

On peut faire une constatation importante en s'aidant de la figure 2. Sur cette figure on voit que la diode D est en parallèle avec la diode D1 et de même la capacité C est en parallèle avec la capacité C2.

C2 et et D1 ont pratiquement les mêmes caractéristiques que C et D. Ainsi, selon les applications (amplitude du signal $V_{in}$) et selon la nature du procédé bipolaire utilisé on peut considérer que le lit épitaxique de la résistance R est en mesure de se polariser seul.

Dans un tel mode de réalisation, le circuit d'interface de la présente invention peut se réduire à une structure intégrée de résistance unique, disposée dans un caisson d'isolement et composée du corps 10 présentant un contact 19 en son point milieu, en plus des contacts d'extrémité (17, 18). La résistance apparait flottante, mais ne l'est pas en réalité, elle est autopolarisée par l'action combinée du signal $V_{in}$ de forte amplitude et de ses éléments parasites (D1, C2, qui fonctionnent de la même façon que les éléments D, C décrits ci-dessus.

On connaît dans la technique, l'utilisation de résistances flottantes dans des applications à faibles signaux (amplitudes inférieures à 100mV) et à très hautes fréquences (supérieures au MHz) cont très différentes de la présente application; cette dernière se caractérisé en effet par l'emploi de forst signaux (amplitudes de l'ordre de quelques volts) et à basses fréquences (inférieures à 20kHz). Dans les applications de l'art antérieur on cherche à réduire au maximum la valeur de la capacité, alors que dans la présente application, cette capacité doit être maintenue à une valeur suffisante pour que, en combinaison avec le signal $V_{in}$ l'autopolarisation soit effective.

Le pavé 15 n'est donc plus nécessaire dans son rôle de région de contact, cependant il peut être avantageux et même parfois obligatoire de la conserver selon les applications. En se référant aux figures 1 et 3, quand le potentiel de l'ensemble SUBSTRAT-ISOLEMENT est $-Vcc=-8,5V$ et que la tension d'entrée $V_{in}$ appliquée au circuit d'interface est $V_{in}=-15V$, il se produit un transistor FET parasite, c'est à dire un canal de conduction, entre le corps de la résistance 10 de type P et le mur d'isolement 12 de type P+, à l'emplacement de la bande conductrice 30 de la métallisation. Le pavé de type N+ qui pouvait être disposé à n'importe quel emplacement du caisson de la résistance R, et qui est rendu inutile par l'autopolarisation de la résistance, peut être conservé et disposé entre le corps et le mur d'isolement. Le pavé 15 sur la figure 3, représente cette solution, son dopage de type N+ bloque l'apparition dudit canal conducteur.

## Revendications

1. Structure monolithique de résistance autopolarisée semiconductrice (R) du genre comportant un corps de résistance (10) d'un premier type de conductivité formé dans un premier caisson (11a) isolé de la couche épitaxiale (11) d'un second type de conductivité, par des murs d'isolement (12) du premier type de conductivité qui rejoignent le substrat (13) dudit premier type de conductivité; le dit corps est muni de deux contacts (17, 18) à ses extrémités, un premier contact (17) recevant un signal d'entrée bipolaire ($V_{in}$) dont l'amplitude est supérieure à la valeur des tensions d'alimentation ($\pm$Vcc) disponibles sur ladite microplaquette caractérisé en ce que:
à ce premier caisson est associé un second caisson de la couche épitaxiale (11b) comportant une diode (D) et une capacité (C), l'anode de la diode est formée par une région (21) du premier type de conductivité formée dans la couche épitaxiale et dont le contact (22) est relié audit signal d'entrée bipolaire; une électrode (23) de la capacité est formée par une région diffusée du second type de conductivité dans le second caisson, et est reliée par un contact (24) à un contact (16) d'une région de contact (15) du premier caisson (11a); l'autre électrode (25) de la capacité est reliée à l'ensemble SUBSTRAT-ISOLEMENT (12, 13).

2. Structure semiconductrice de résistance autopolarisée selon la revendication 1 caractérisée en ce que une région fortement dopée (15') du second type de conductivité est disposée entre le corps (10) de la résistance et les murs d'isolement (12) dans la couche épitaxiale sous le conducteur (30) qui amène le signal d'entrée ($V_{in}$).

3. Structure semiconductrice de résistance autopolarisée selon la revendication 1 ou 2 caractérisée en ce que le second contact (18) du corps de résistance (10) est relié à la masse et qu'un contact intermédiaire (19) est placé sur le corps de la résistance sur lequel le signal de sortie ($V_{out}$) est disponible.

## Patentansprüche

1. Monolithische Struktur eines selbstgepolten Halbleiterwiderstandes (R) vom Typ mit einem Widerstandskörper (10) mit einem ersten Leitfähigkeitstyp, aus einem ersten Kasten (11a) gebildet, der von der Epitaxialschicht (11) mit einem

zweiten Leitfähigkeitstyp durch Isolierwände (12) vom ersten Leitfähigkeitstyp isoliert ist, welche mit dem Substrat (13) vom besagten ersten Leitfähigkeitstyp in Verbindung stehen; der besagte Körper ist mit zwei Kontakten (17, 18) an seinen Enden verbunden, von denen ein erster (17) ein zweipoliges Eingangssignal ($V_{in}$) aufnimmt, dessen Amplitude grösser ist als der Wert der Versorgungsspannungen ($\pm V_{ss}$), die am besagten Mikroplättchen anstehen, dadurch gekennzeichnet, dass:

der erste Kasten einem zweiten der Epitaxialschicht (11b) zugeordnet ist, der einen Diode (D) und einen Kondensator (C) enthält, wobei die Anode der Diode durch eine Zone (21) vom ersten Leitfähigkeitstyp gebildet wird, die in der Epitaxialschicht entsteht, und deren Kontakt (22) mit dem besagten Signal mit zweipoligem Eingang verbunden ist; eine Elektrode (23) des Kondensators ist durch eine diffundierende Zone vom zweiten Leitfähigkeitstyp im zweiten Kasten gebildet, und durch einen Kontakt (24) mit einem Kontakt (16) einer Kontaktzone (15) des ersten Kastens (11a) verbunden; die andere Elektrode (25) des Kondensators ist mit der Einheit SUBSTRAT-ISOLIERUNG (12, 13) verbunden.

2. Halbleiterstruktur mit selbstgepoltem Widerstand gemäss Anspruch 1, dadurch gekennzeichnet, dass eine stark dotierte Zone (15') vom zweiten Leitfähigkeitstyp zwischen dem Körper (10) des Widerstandes und den Isolierwänden (12) in der Epitaxialschicht unter dem Leiter (30) angeordnet ist, der das Eingangssignal ($V_{in}$) anlegt.

3. Halbleiterstruktur mit selbstgepoltem Widerstand gemäss Anspruch 1 oder 2, dadurch gekennzeichnet, dass der zweite Kontakt (18) des Widerstandskörpers (18) an die Masse gelegt ist und dass ein Zwischenkontakt (19) am Widerstandskörper angeordnet ist, an dem das Ausangssignal ($V_{out}$) ansteht.

**Claims**

1. A monolithic autobiased resistor structure (R) of the type including a resistor body (10) of a first type of conductivity, formed in a first pocket (11a) isolated from epitaxial layer (11) of a second type of conductivity by insulation walls (12) of the first type of conductivity extending to substrate (13) of said first type of conductivity, said body being provided with two end contacts (17, 18), one contact (17) receiving a bipolar input signal ($V_{in}$) the amplitude of which is higher than the values of the voltage supplies ($\pm Vcc$) available on sid chip, characterized in that:

said first pocket is associated with a second pocket (11b) of the epitaxial layer including a diode (D) and a capacitor (C), the diode anode is formed of a region (21) of the first type of conductivity diffused in the epitaxial layer and contact (22) of which is connected to said bipolar input signal, an electrode (23) of the capacitor is formed by a diffused region of the second type of conductivity in the second pocket, and is connected by a contact (24) to a contact (16) of a contact region 15) of first pocket (11a), and the other electrode of capacitor (25) is connected to SUBSTRATE-INSULATION-assembly (12, 13).

2. A semi-conducting autobiased resistor structure according to claim 1 characterized in that a heavily doped region (15') of the second type of conductivity is arranged between resistor body (10) and insulation walls (12) in the epitaxial layer under conductor (30) which carries input signal ($V_{in}$).

3. A semi-conducting autobiased resistor structure according to claim 1 or 2 characterized in that second contact (18) of resistor body (10) is connected in the ground and in that an intermediate contact (19) is provided on the resistor body from which output signal ($V_{out}$) is available.

FIG. 1

FIG. 2

FIG. 3